# EUROPÄISCHE PATENTSCHRIFT

(11) **EP 1 631 121 B1**
(45) Veröffentlichungstag und Bekanntmachung des Hinweises auf die Patenterteilung: **17.10.2007**
(21) Anmeldenummer: 04017775.0
(22) Anmeldetag: 27.07.2004
(51) Int. Cl.: H05B 3/00, H05B 3/42

(54) **Infrarotheizelement und Vakuumkammer mit Substratheizung, insbesondere für Vakuumbeschichtungsanlagen**
Infrared heating element and vacuum chamber with substrate heating, in particular for vacuum coating instalations
Elément chauffant infrarouge et chambre à vide avec chauffage de substrat, notemment pour installations de revêtement sous vide

(43) Veröffentlichungstag der Anmeldung: 01.03.2006
(73) Patentinhaber: Applied Materials GmbH & Co. KG, 63755 Alzenau (DE)
(72) Erfinder: Haas, Dieter, 63486 Bruchköbel (DE)
(74) Vertreter: GROSSE BOCKHORNI SCHUMACHER

(56) Entgegenhaltungen:
- US-A- 3 562 006
- US-A- 5 350 927
- US-A- 5 915 072
- PATENT ABSTRACTS OF JAPAN Bd. 018, Nr. 433 (C-1237), 12. August 1994 (1994-08-12) -& JP 06 134040 A (KATSUYOSHI INAI), 17. Mai 1994 (1994-05-17)
- PATENT ABSTRACTS OF JAPAN Bd. 013, Nr. 280 (E-779), 27. Juni 1989 (1989-06-27) -& JP 01 067885 A (TOSHIBA CORP), 14. März 1989 (1989-03-14)
- PATENT ABSTRACTS OF JAPAN Bd. 013, Nr. 102 (P-841), 10. März 1989 (1989-03-10) -& JP 63 281181 A (CANON INC), 17. November 1988 (1988-11-17)

## Beschreibung

Die Erfindung betrifft ein Infrarotheizelement und eine Vakuumkammer mit Substratheizung, insbesondere für Vakuumbeschichtungsanlagen, gemäß dem Oberbegriff von Anspruch 1 bzw. Anspruch 10.

Für bestimmte Prozesse kann das Substrat nicht direkt über Wärmeleitung geheizt werden. Zum Beispiel kann das Substrat auf einem verfahrbaren Substrathalter (Carrier) befestigt werden, der das Substrat durch verschiedene Prozesskammern bewegt. Einen solchen Carrier mit einer Heizplatte, z.B. einem BN-Widerstandssubstratheizer auszurüsten, ist mit Schwierigkeiten verbunden. Es sind elektrische Schleifkontakte nötig, die Spannungen führen und eventuell durch Abrieb Partikel generieren. Im Bereich der Sputterkathoden können an den unter Spannung stehenden Kontakten Nebenplasmen entstehen, die die Plasmaentladung der Sputterkathoden stören oder zu Überschlägen führen können. Partikel, die sich auf dem Substrat absetzen, können zu sogenannten "Pinholes" führen, indem diese Partikel nach der Beschichtung vom Substrat abfallen, oder als Störung in einer Funktionsschicht auf dem Substrat verbleiben. Außerdem ist es aufwändig, Kontaktflächen für eine Heizplatte mit einer so glatten und ebenen Oberfläche herzustellen, dass der vollflächige Wärmeübergang zum Substrat gewährleistet ist. Liegt das Substrat nur punktuell auf der Heizfläche auf, kann ein empfindliches Substrat durch thermische Spannungen zerstört werden, da im Vakuum kein Kontaktmedium vorhanden ist, das den Wärmeübergang herstellt, wie z.B. die Luft an Atmosphäre. Darüber hinaus müsste für jede Substratform eine angepasste Heizoberfläche Eine räumliche Wärmeübertragung kann durch Wärmeleitung, Wärmestrahlung und Wärmekonvektion erfolgen. Für die Nutzung von Wärmestrahlung sind vielfältige Anwendungen bekannt.

So offenbart die Druckschrift US 5,915,072 A einen Heizstrahler zur Wärmebehandlung von Patienten, insbesondere Säuglingen. Das Heizelement des Heizstrahlers ist in einem Quarzrohr angeordnet, welches wiederum in einem beidseitig beschichteten Metallrohr angeordnet ist. Durch die Beschichtung des Metallrohres wird Infrarotstrahlung von der Innenschicht besonders gut absorbiert und von der Außenschicht besonders gut abgestrahlt. Weiterhin bewirkt die Beschichtung eine Verschiebung der Infrarotstrahlen, so dass keine rote Hautfarbe der Säuglinge vorgetäuscht wird und daher eine Blaufärbung der Hautfarbe bei Atemnot erkennbar bleibt.

Die Druckschrift JP 06 134040 A offenbart ebenfalls einen Heizstrahler. Der Heizstrahler strahlt im langwelligen fernen Infrarotbereich und eignet sich insbesondere für den Einsatz in Badezimmern und Saunen. Der Heizstrahler ist in ein Metallrohr eingesetzt und das Metallrohr ist mit einer Substanz mit stark absorbierenden Eigenschaften beschichtet. Die vom Heizstrahler generierte Wärme wird zum Metallrohr übertragen und in Form von Infrarotstrahlung von der Oberfläche des Metallrohres abgestrahlt.

Als weiteres Beispiel offenbart die Druckschrift JP 01 067885 A einen Infrarotstrahler, der in ein Metallrohr eingesetzt ist. Das Metallrohr besteht aus einer Eisenlegierung, die Aluminium enthält, welches unter Wärmeeinfluss an der Oberfläche des Metallrohres oxidiert. Die entstehende Oxidschicht ist alterungs- und hitzebeständig.

Weiterhin offenbart die Druckschrift JP 63 281181 A eine Vorrichtung zum Prüfen der Effizienz von berührungslosen Heizern. Verwendet wird ein Halogenstrahler, dessen Wolframdraht in einer Quarzglasröhre angeordnet ist. Auf die Quarzglasröhre ist eine Aluminiumschicht und auf die Aluminiumschicht eine Funktionsschicht aufgebracht, die Infrarotstrahlung des fernen Infrarotbereichs emittiert.

Während die Wärmeleitung durch Molekülstöße erfolgt und damit ein Temperaturgefälle in Materie voraussetzt, ist die Wärmeströmung an makroskopische Bewegungen in Flüssigkeiten oder Gasen gebunden, deren Wärmeinhalt an andere Stellen transportiert wird. Die Wärmestrahlung ist elektromagnetischer Natur. hergestellt werden, die dann auch noch gegen z.B. Verkratzen oder Verschmutzen geschützt werden müsste.

Das Substrat kann nicht nur liegend auf dem Substrathalter transportiert werden sondern auch in senkrechter Position. Es ist dabei in einem Rahmen oder Gestell eingesetzt und mittels Federn gehalten, wobei der Substratträger am unteren Ende auf Rollen läuft und am oberen Ende magnetisch in Position gehalten wird. Ein solcher Substrattransport wird beispielsweise in der CH 691 680 A beschrieben.

Andererseits ist es besonders bei großflächigen Substraten auch denkbar, das Substrat über ein Transportsystem aus z.B. Rollen durch die Vakuumanlage zu transportieren. Auch in diesem Fall ist eine Heizung des Substrates über Wärmeleitung nicht möglich, da das Substrat freiliegt.

Wenn Wärmeleitung im Vakuum nicht möglich ist, kommt für die Wärmeübertragung nur Wärmestrahlung infrage. Die Energieverteilung der Wärmestrahlung wird mit Hilfe des idealen schwarzen Strahlers beschrieben und es gilt das Plancksche Strahlungsgesetz. Es beschreibt die spektrale Energieverteilung des schwarzen Strahlers mit einem Energiemaximum und geringen Strahlungsenergien für sehr niedrige und sehr hohe Wellenlängen der Strahlung.

Infrarotstrahlung wird aufgrund ihrer größeren Wellenlänge (λ > 0,75µm) wesentlich besser von Materialien absorbiert als Strahlung im Bereich des sichtbaren Lichts (0,4µm < λ < 0,75µm). Zurückzuführen ist diese Absorption im Infraroten auf Schwingungen der Ionen in den Materialien. Zur Erzeugung von Infrarotstrahlung werden häufig Temperaturstrahler eingesetzt. Dementsprechend sind Infrarotheizelemente Vorrichtungen, die bei Einwirkung von Wärme Wärmestrahlung im Bereich des Infraroten des Spektrums abgeben.

Problematisch an solchen Temperaturstrahlern ist es, dass neben der Infrarotstrahlung immer Strahlung im sichtbaren Bereich sowie ultravioletten Bereich abgegeben wird. Dadurch ist die übertragene Heizleistung im Vergleich zur gesamten abgestrahlten Leistung beschränkt. Entsprechend dem Planckschen Strahlungsgesetz ist das Maximum der Energieverteilung und die Gesamtenergiedichte eines schwarzen Strahlers nur von seiner Temperatur abhängig und kann durch das Wiensche Verschiebungsgesetz (νₘₐₓ ~ T) bzw. das Stefan-Boltzmann-Gesetz (R = σT⁴, σ ist eine Konstante) beschrieben werden. Die Relation zwischen einem realen Temperaturstrahler und einem schwarzen Strahler wird durch das Emissionsvermögen ε (0 ≤ ε ≤ 1, 1 entspricht einem idealen schwarzen Strahler) beschrieben, so dass R = εσT⁴ folgt.

Aufgabe der vorliegenden Erfindung ist es, ein Infrarotheizelement zur Verfügung zu stellen, welches insbesondere im Vakuum sehr effektiv durch Wärmestrahlung Wärme überträgt. Eine weitere Aufgabe der vorliegenden Erfindung ist es, eine Substratheizung, insbesondere für Vakuumbeschichtungsanlagen zur Verfügung zu stellen, die eine sehr effektive Heizung eines Substrats mittels Wärmestrahlung ermöglicht. Effektiv heißt in diesem Zusammenhang, dass zum einen das Verhältnis von gesamter abgestrahlter Energie zu Wärmestrahlungsenergie, die zum Heizen Verwendung findet, optimiert ist, also Verluste reduziert werden. Zum anderen soll aber auch die Temperatur des Heizelements im Vergleich zur erzielten Temperatur des zu heizenden Objekts gering gehalten werden.

Diese Aufgaben werden erfindungsgemäß gelöst durch ein Infrarotheizelement gemäß Anspruch 1 und eine Substratheizung gemäß Anspruch 10. Vorteilhafte Weiterbildungen der Erfindung sind durch die in den Unteransprüchen enthaltenen Merkmale gekennzeichnet.

Das erfindungsgemäße Infrarotheizelement besteht aus einer Heizquelle, die von einer Schutzeinrichtung umgeben ist, die als Mantellrohr aus Metall ausgeführt ist. Das Mantelrohr ist wenigstens teilweise mit einer Infrarot-emittierenden Schicht versehen. Die Umhüllung der Heizquelle in Form eines Mantelrohres aus Metall schützt die Heizquelle nicht nur, sie bewirkt auch eine gleichmäßige Wärmeverteilung durch Wärmeleitung innerhalb des Mantelrohres. Dadurch dass das Mantelrohr wenigstens teilweise mit einer Infrarot-emittierenden Schicht versehen ist, wird die Effektivität der Wärmeabstrahlung erhöht und die Manteltemperatur kann unter Beibehaltung der abgestrahlten Wärmeenergie abgesenkt werden.

Vorteilhaft ist es, wenn das Metall ein Emissionsvermögen zwischen 0,1 und 0,4 und die Infrarot-emittierende Schicht ein Emissionsvermögen von mehr als 0,7, bevorzugt mehr als 0,8 und insbesondere mehr als 0,9 aufweist. Eine solche Infrarot-emittierende Schicht kommt einem schwarzen Strahler in seiner spektralen Energieverteilung sehr nahe. Das Mantellrohr selbst dient dann nicht der Wärmeabstrahlung sondern heizt über Wärmeleitung die Infrarot-emittierende Schicht.

Zweckmäßig ist die Heizquelle als Widerstandsheizung in Form eines Heizdrahtes aus z.B. Wolfram ausgeführt. Während als Material für das Metall-Mantelrohr vorteilhaft Edelstahl oder die hochtemperaturfeste Legierung Inconel^{®} verwendet wird, empfiehlt sich für die Infrarot-emittierende Schicht die Verwendung eines Metalloxids. Diese Metalloxide sind als sehr gute Infrarot-Emitter bekannt. Zweckmäßig wird TiO₂ als Metalloxid verwendet. Besonders gut wird eine solche Metalloxidschicht auf dem Mantelrohr mittels Plasmaspritzen aufgebracht, aber auch Sputtern ist möglich. So können dünne, gleichmäßige Schichten von etwa 10nm Dicke bis zu einigen Millimetern aufgebracht werden.

Die Abstrahlcharakteristik des Infrarotheizelements kann dadurch beeinflusst werden, dass nur diejenigen Bereiche des Mantelrohres mit einer Infrarot-emittierenden Schicht versehen sind, die zur Infrarotabstrahlung beitragen sollen. So werden bestimmte Raumwinkel nicht einer intensiven Infrarotstrahlung ausgesetzt, sondern nur der Abstrahlung des Mantellrohres, die im Infraroten geringer ist, als die der Infrarot-emittierenden Schicht. Durch das Mantelrohr wird eine direkte Energieabstrahlung der Heizquelle in diese Raumwinkelbereiche verhindert und ein Teil dieser Energie durch Wärmeleitung innerhalb des Mantelrohres zum Heizen der Infrarot-emittierende Schicht verwendet. Dadurch kann die Effizienz des Infrarotheizelements noch weiter erhöht werden.

Die erfindungsgemäße Vakuumkammer mit Substratheizung umfasst ein Substrat und wenigstens ein benachbart zu diesem angeordnetes Heizelement, das als erfindungsgemäßes Infrarotheizelement ausgeführt ist, wobei das Substrat und das Infrarotheizelement thermisch entkoppelt sind. Thermische Entkopplung heißt in diesem Zusammenhang, dass weitestgehend keine Wärmeleitung oder -konvektion auftritt. Durch diese thermische Entkopplung wird erreicht, dass die Erwärmung ausschließlich über Wärmestrahlung des Infrarotheizelements erfolgt. Deshalb geschieht das Heizen des Substrates über Infrarotbestrahlung mit Hilfe des Infrarotheizelements sehr effektiv. Außerdem kann das Heizen sehr gezielt erfolgen, da die Substrattemperatur direkt über die Heizleistung des Infrarotheizelements einstellbar ist.

Zweckmäßig wird die Substratheizung von den Wänden der Vakuumkammer durch eine Wärmedämmvorrichtung isoliert, die ebenfalls thermisch entkoppelt ist. So können Wärmeverluste vermieden und eine unerwünschte Erwärmung, insbesondere der Wände von Vakuumbeschichtungsanlagen verhindert werden.

Bevorzugt ist das wenigstens eine Infrarotheizelement mit seiner Längsachse parallel zur Substratoberfläche ausgerichtet angeordnet. So kann das Substrat sehr effektiv geheizt werden.

Vorteilhaft ist es, wenn das Metallmantelrohr des wenigstens einen Infrarotheizelements eine Infrarot-emittierende Schicht mit der Gestalt eines Zylinderlängssegments aufweist und dieses so angeordnet ist, dass es auf das Substrat weist. Auf diese Weise erfolgt das Heizen unter Reduzierung der Verluste, da nur das Substrat einer intensiven Infrarotstrahlung ausgesetzt wird.

Bevorzugt ist die Anzahl der Infrarotheizelemente so gewählt, dass in Abhängigkeit von der zu heizenden Substratfläche und des Abstands der Infrarotheizelemente und ihrer Größe eine möglichst gleichmäßige Infrarotbestrahlung des Substrats erfolgt. Somit erfolgt das Heizen des Substrates gleichmäßig und damit weitgehend spannungsfrei.

Für bestimmte Prozesse muss das Substrat auf einem verfahrbaren Substrathalter (Carrier) befestigt werden, der das Substrat durch verschiedene Prozesskammern bewegt. Das Substrat ist dabei mit dem Substrathalter auf bekannte Weise verbunden. In diesem Fall wird das Substrat ebenfalls direkt über Wärmestrahlung durch das Infrarotheizelement geheizt. Dies kann z.B. dadurch geschehen, dass das Substrat in senkrechter Position auf dem Substrathalter transportiert wird. Das Substrat wird dann auf dem Transport durch die Anlage von beiden Seiten geheizt, um eine gleichmäßige Erwärmung zu gewährleisten. Nur im Bereich von Beschichtungsstationen wird das Substrat einseitig von der der Beschichtungsseite abgewandten Rückseite geheizt, damit die Temperatur des Substrats während des Beschichtungsprozesses nicht zu stark absinkt.

Möglich ist es aber auch, die Substratheizung auf der in Bezug auf das Substrat gegenüberliegenden Seite des Substrathalters anzuordnen, oder dass der Substrathalter großflächige Durchbrüche oder dergleichen aufweist oder rahmenförmig ausgeführt ist, so dass eine großflächige und gleichmäßige Wärmebestrahlung des Substrates von beiden Seiten des Substrates erfolgen kann.

Mit Hilfe der erfindungsgemäßen Vakuumkammer mit Substratheizung wird also eine einfache Substrattemperung z.B. während Beschichtungsprozessen ermöglicht, wenn der Substrathalter wegen bestimmter Prozessparameter nicht direkt über Wärmeleitung heizbar ist.

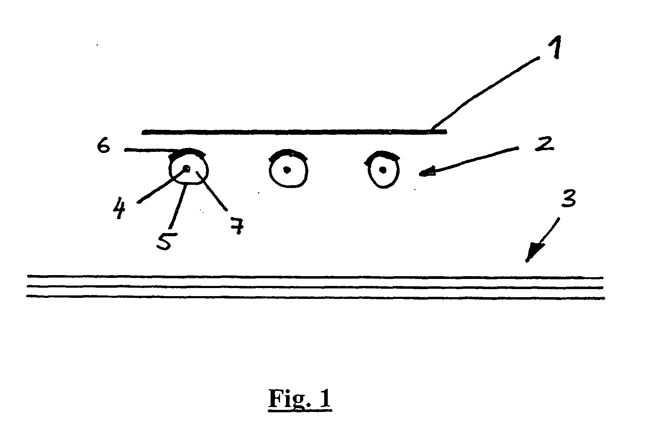

Im folgenden wird ein Ausführungsbeispiel anhand einer Zeichnung näher erläutert, darin zeigt die Figur einen Schnitt durch eine erfindungsgemäße Substratheizung.

In einer Ausführungsform der vorliegenden Erfindung umfasst eine Substratheizung ein Substrat 1, drei Infrarotheizelemente 2 und eine Wärmedämmvorrichtung 3. Die Infrarotheizelemente 2 sind dabei thermisch entkoppelt zwischen dem Substrat 1 und der Wärmedämmvorrichtung 3 in einem Abstand von etwa 2 cm angeordnet. Die Wärmedämmvorrichtung 3 zur Wärmedämmung der Vakuumkammer besteht aus einem Paket von drei hintereinander angeordneten spiegelnden Strahlungsblechen. Die Bleche weisen einen Emissionskoeffizienten von ε < 0,1 auf. Durch die Verwendung dieser nicht in thermischem Kontakt stehenden Bleche im Vakuum kann ein Austausch von thermischer Energie nur über Wärmestrahlung stattfinden. Die Wärmeabstrahlung der Bleche ist aber wegen ihres kleinen Emissionskoeffizienten relativ gering. Wird z.B. das erste Blech der Wärmedämmvorrichtung 3 durch die Infrarotheizer 2 auf ca. 500°C aufgeheizt, so hat das zweite Strahlungsblech nur noch eine Temperatur von ca. 400°C, während das der Kammerwand gegenüberstehende letzte Blech nur noch eine Temperatur von 300 °C aufweist.

Als Heizquellen der Infrarotheizelemente 2 kommen bekannte Wolframheizdrähte 4 zum Einsatz, die auf bekannte Weise mit Strom versorgt und diese Stromversorgung mit einem Regelkreis in Abhängigkeit der einzustellenden Substrattemperatur gesteuert wird. Die Wolframheizdrähte 4 sind jeweils von einer verdichteten Quarzsandfüllung 7 und Mantelrohren 5 aus Inconel^{®} umhüllt. Die Mantelrohre 5 sind dabei gegenüber den jeweiligen Wolframheizdrähten 4 elektrisch isoliert. Die Mantelrohre 5 sind auf ihrer zum Substrat 1 weisenden Oberfläche mit einer TiO₂-Schicht 6 als Infrarot-emittierende Schicht versehen. Die TiO₂-Schicht 6 weist eine Dicke von 100µm auf und wurde mittels Plasmaspritzen auf dem Mantelrohr 5 aufgebracht. Die Beschichtung kann jedoch auch mittels Sputtern aufgebracht sein, wobei dann dünnere Schichten im Bereich von 10nm und mehr bevorzugt werden.

Bei einem Abstand der erfindungsgemäßen Infrarotheizelemente 2 vom Substrat 1 von 2 bis 5 cm sind für Substrattemperaturen von mehr als 400°C Manteltemperaturen von ca. 600°C erforderlich. Im Vergleich zu reinen Mantelheizern aus Metall, bei denen für Substrattemperaturen von mehr als 400°C Manteltemperaturen von mehr als 850°C erforderlich sind, liegen diese Manteltemperaturen weit entfernt vom Schmelzpunkt des Metallmantels 5 (etwa 1100°C). Die Manteltemperatur kann mit der erfindungsgemäßen Substratheizung also auf unkritische Temperaturen abgesenkt und die Verluste bei einem Substratheizen mittels Wärmestrahlung reduziert werden.

## Patentansprüche

1. Infrarotheizelement (2) zum das Heizen eines Substrates mittels Wärmestrahlung, insbesondere im Vakuum, mit einer Heizquelle (4) und einer Schutzeinrichtung, wobei die Schutzeinrichtung ein Metallmantelrohr (5) ist, welches die Heizquelle umhüllt, **dadurch gekennzeichnet, dass**
das Metallmantelrohr (5) teilweise mit einer Infrarot- emittierenden Schicht (6) versehen ist.

2. Infrarotheizelement (2) gemäß Anspruch 1, **dadurch gekennzeichnet, dass** das Metall ein Emissionsvermögen zwischen 0,1 bis 0,4 und die Infrarot-emittierende Schicht (6) ein Emissionsvermögen von mehr als 0,7, insbesondere mehr als 0,8 und bevorzugt mehr als 0,9 aufweist.

3. Infrarotheizelement (2) gemäß Anspruch 1 oder 2, **dadurch gekennzeichnet, dass** die Heizquelle (4) als Heizdraht einer Widerstandsheizung ausgeführt ist.

4. Infrarotheizelement (2) gemäß einem der Ansprüche 1 bis 3, **dadurch gekennzeichnet, dass** die Infrarot-emittierenden Schicht (6) eine Metalloxidschicht umfasst.

5. Infrarotheizelement (2) gemäß Anspruch 4, **dadurch gekennzeichnet, dass** die Metalloxidschicht TiO₂ umfasst.

6. Infrarotheizelement (2) gemäß Anspruch 5, **dadurch gekennzeichnet, dass** die TiO₂-Schicht eine Dicke von 10nm bis zu einigen Millimetern, bevorzugt 50nm bis 500µm, insbesondere 100nm bis 100µm aufweist.

7. Infrarotheizelement (2) gemäß einem der vorhergehenden Ansprüche, **dadurch gekennzeichnet, dass** die Infrarot-emittierende Schicht (6) mittels Plasmaspritzen auf dem Metallmantelrohr (5) aufgebracht ist.

8. Infrarotheizelement (2) gemäß einem der vorhergehenden Ansprüche, **dadurch gekennzeichnet, dass** das Metallmantelrohr (5) Edelstahl oder Inconel^{®} umfasst.

9. Infrarotheizelement (2) gemäß einem der vorhergehenden Ansprüche, **dadurch gekennzeichnet, dass** das Metallmantelrohr (5) ausschließlich in den Oberflächenbereichen mit einer Infrarot-emittierenden Schicht (6) versehen ist, die zur Infrarotabstrahlung vorgesehen sind.

10. Vakuumkammer mit Substratheizung, insbesondere für Vakuumbeschichtungsanlagen, die ein Substrat (1) und wenigstens ein benachbart angeordnetes Heizelement umfasst, **dadurch gekennzeichnet, dass** das Heizelement als Infrarotheizelement (2) gemäß einem der Ansprüche 1 bis 9 ausgeführt und von dem Substrat (1) dahingehend thermisch entkoppelt ist, dass zwischen Substrat (1) und Infrarotheizelement (2) keine Wärmeleitung oder Wärmekonvektion auftreten.

11. Vakuumkammer gemäß Anspruch 10, **dadurch gekennzeichnet, dass** in der Vakuumkammer eine Wärmedämmvorrichtung (3) zur Wärmedämmung der Vakuumkammer so vorgesehen sind, dass das wenigstens eine Infrarotheizelement (2) thermisch entkoppelt zwischen dem Substrat (1) und der Wärmedämmvorrichtung (3) angeordnet ist.

12. Vakuumkammer gemäß Anspruch 10 oder 11, **dadurch gekennzeichnet, dass** das wenigstens eine Infrarotheizelement (2) mit seiner Längsachse parallel zur Substratoberfläche angeordnet ist.

13. Vakuumkammer gemäß einem der Ansprüche 10 bis 12, **dadurch gekennzeichnet, dass** das Metallmantelrohr (5) des wenigstens einen Infrarotheizelements (2) eine Infrarot-emittierende Schicht (6) der Gestalt eines Zylinderlängssegments aufweist und dieser auf das Substrat (1) weisend angeordnet ist.

14. Vakuumkammer gemäß einem der Ansprüche 10 bis 13, **dadurch gekennzeichnet, dass** das die Anzahl der Infrarotheizelemente (2) in Abhängigkeit von der zu heizenden Substratfläche so gewählt ist, dass eine möglichst gleichmäßige Infrarotbestrahlung des Substrats (1) erfolgt.

15. Vakuumkammer gemäß einem der Ansprüche 10 bis 14, **dadurch gekennzeichnet, dass** ein Substrathalter vorgesehen ist, auf dem das Substrat 1 angeordnet ist.

## Claims

1. An infrared heating element (2) for heating a substrate in a vacuum chamber, comprising a heating source (4) and a protective means, **characterized in that** said protective means is designed as a tubular metal jacket (5) which sheathes said heating source and which is provided at least to an extent with an infrared-emitting layer (6).

2. An infrared heating element (2) according to claim 1, **characterized in that** the metal has an emittance of between 0.1 to 0.4 and said infrared-emitting layer (6) has an emittance of more than 0.7, particularly more than 0.8 and preferably more than 0.9.

3. An infrared heating element (2) according to claim 1 or 2, **characterized in that** said heating source (4) is designed as a heating wire of a resistance heater.

4. An infrared heating element (2) according to any of claims 1 to 3, **characterized in that** said infrared-emitting layer (6) comprises a metal oxide layer.

5. An infrared heating element (2) according to claim 4, **characterized in that** said metal oxide layer comprises TiO₂.

6. An infrared heating element (2) according to claim 5, **characterized in that** said TiO₂ layer has a thickness of 10 nm up to several millimetres, preferably 50 nm to 500 µm, particularly 100 nm to 100 µm.

7. An infrared heating element (2) according to any of the preceding claims, **characterized in that** said infrared-emitting layer (6) is applied to said tubular metal jacket (5) by means of plasma spraying.

8. An infrared heating element (2) according to any of the preceding claims, **characterized in that** said tubular metal jacket (5) comprises high-grade steel or Inconel^{®}.

9. An infrared heating element (2) according to any of the preceding claims, **characterized in that** said tubular metal jacket (5) is provided with an infrared-emitting layer (6) only in those surface regions which are provided for infrared radiation.

10. A substrate heater type vacuum chamber, particularly for vacuum coating facilities, comprising a substrate (1) and at least one heating element positioned adjacent thereto, **characterized in that** said heating element is designed as an infrared heating element (2) in accordance with any of claims 1 to 9 and is thermally decoupled from said substrate (1) to the effect that no thermal conduction or thermal convection can arise between said substrate (1) and said infrared heating element (2).

11. A vacuum chamber according to claim 10, **characterized in that** said vacuum chamber includes a thermal insulation means (3) for thermally insulating said vacuum chamber such that said at least one infrared heating element (2) is positioned between said substrate (1) and said thermal insulation means (3) in a thermally decoupled manner.

12. A vacuum chamber according to claim 10 or 11, **characterized in that** said at least one infrared heating element (2) is positioned with its longitudinal axis parallel to the substrate surface.

13. A vacuum chamber according to any of claims 10 to 12, **characterized in that** said tubular metal jacket (5) of said at least one infrared heating element (2) comprises an infrared-emitting layer (6) designed as a cylindrical longitudinal segment, and said segment is positioned to face towards said substrate (1).

14. A vacuum chamber according to any of claims 10 to 13, **characterized in that** the number of said infrared heating elements (2) is chosen as a function of the substrate surface which is to be heated, the number being chosen such that said substrate (1) is exposed to infrared radiation in as even a manner as possible.

15. A vacuum chamber according to any of claims 10 to 14, **characterized in that** a substrate holder is provided, said substrate (1) being disposed thereon.

## Revendications

1. Élément chauffant infrarouge (2) pour le chauffage d'un substrat au moyen d'un rayonnement thermique, en particulier sous vide, comprenant une source de chauffage (4) et un dispositif de protection, dans lequel le dispositif de protection est une gaine tubulaire métallique (5) qui entoure la source de chauffage, **caractérisé en ce que** la gaine tubulaire métallique (5) est en partie pourvue d'une couche émettrice d'infrarouge (6).

2. Élément chauffant infrarouge (2) selon la revendication 1, **caractérisé en ce que** le métal présente une émissivité comprise entre 0,1 et 0,4 et la couche émettrice d'infrarouge (6) présente une émissivité de plus de 0,7, en particulier de plus de 0,8 et de préférence de plus de 0,9.

3. Élément chauffant infrarouge (2) selon la revendication 1 ou 2, **caractérisé en ce que** la source de chauffage (4) est conçue en tant que filament chauffant d'un chauffage ohmique.

4. Élément chauffant infrarouge (2) selon l'une quelconque des revendications 1 à 3, **caractérisé en ce que** la couche émettrice d'infrarouge (6) comprend une couche d'oxyde métallique.

5. Élément chauffant infrarouge (2) selon la revendication 4, **caractérisé en ce que** la couche d'oxyde métallique comprend du TiO₂.

6. Élément chauffant infrarouge (2) selon la revendication 5, **caractérisé en ce que** la couche de TiO₂ présente une épaisseur de 10 nm à quelques millimètres, de préférence de 50 nm à 500 µm, en particulier de 100 nm à 100 µm.

7. Élément chauffant infrarouge (2) selon l'une quelconque des revendications précédentes, **caractérisé en ce que** la couche émettrice d'infrarouge (6) est déposée sur la gaine tubulaire métallique (5) au moyen d'une projection au plasma.

8. Élément chauffant infrarouge (2) selon l'une quelconque des revendications précédentes, **caractérisé en ce que** la gaine tubulaire métallique (5) comprend de l'acier fin ou de l'Inconel^{®}.

9. Élément chauffant infrarouge (2) selon l'une quelconque des revendications précédentes, **caractérisé en ce que** la gaine tubulaire métallique (5) est pourvue d'une couche émettrice d'infrarouge (6) exclusivement dans les zones superficielles, laquelle couche est prévue pour le rayonnement infrarouge.

10. Chambre à vide avec un chauffage de substrat, en particulier pour des dispositifs de dépôt sous vide, qui comprend un substrat (1) et au moins un élément chauffant avoisinant, **caractérisé en ce que** l'élément chauffant est conçu en tant qu'élément chauffant infrarouge (2) selon l'une quelconque des revendications 1 à 9 et qu'il est thermiquement découplé du substrat (1) pour qu'il ne se produise aucune conduction ou convection de chaleur entre le substrat (1) et l'élément chauffant infrarouge (2).

11. Chambre à vide selon la revendication 10, **caractérisé en ce qu'**un dispositif d'isolation thermique (3) est prévu dans la chambre à vide pour l'isolation thermique de la chambre à vide de manière à ce que le au moins un élément chauffant infrarouge (2) soit disposé en étant thermiquement découplé entre le substrat (1) et le dispositif d'isolation thermique (3).

12. Chambre à vide selon la revendication 10 ou 11, **caractérisé en ce que** le au moins un élément chauffant infrarouge (2) est disposé avec son axe longitudinal parallèlement à la surface du substrat.

13. Chambre à vide selon l'une quelconque des revendications 10 à 12, **caractérisé en ce que** la gaine tubulaire métallique (5) du au moins un élément chauffant infrarouge (2) présente une couche émettrice d'infrarouge (6) sous la forme d'un segment longitudinal cylindrique et que celui-ci est dirigé vers le substrat (1).

14. Chambre à vide selon l'une quelconque des revendications 10 à 13, **caractérisé en ce que** le nombre d'éléments chauffants infrarouge (2) est choisi en fonction de la surface du substrat à chauffer de manière à obtenir une irradiation infrarouge du substrat (1) la plus homogène possible.

15. Chambre à vide selon l'une quelconque des revendications 10 à 14, **caractérisé en ce qu'**un support de substrat, sur lequel est disposé le substrat 1, est prévu.
